# EUROPÄISCHE PATENTSCHRIFT

(11) **EP 0 413 394 B1**
(45) Veröffentlichungstag und Bekanntmachung des Hinweises auf die Patenterteilung: **18.11.1993**
(21) Anmeldenummer: 90202191.4
(22) Anmeldetag: 13.08.1990
(51) Int. Cl.: C23C 16/26

(54) **Verfahren zur Herstellung polykristalliner Diamantschichten**
Method for obtaining polycrystallinic diamond layers
Méthode pour obtenir des couches de diamant polycristallin

(30) Priorität: 17.08.1989 DE 3927136
(43) Veröffentlichungstag der Anmeldung: 20.02.1991
(73) Patentinhaber: Philips Patentverwaltung GmbH, 22335 Hamburg (DE); Philips Electronics N.V., 5621 BA Eindhoven (NL)
(72) Erfinder: Bachmann, Peter Klaus, Dr. Ing., D-5100 Aachen (DE); Lydtin, Hans, Dr., D-5190 Stolberg (DE); Ritz, Arnd, Dr., D-5142 Hückelhoven (DE)
(74) Vertreter: Kupfermann, Fritz-Joachim, Dipl.-Ing.

(56) Entgegenhaltungen:
- PATENT ABSTRACTS OF JAPAN, Band 11, Nr. 349 (C-456), 14. November 1987; & JP-A-62 123 096
- PATENT ABSTRACTS OF JAPAN, Band 13, Nr. 115 (C-578)[3463], 20. März 1989; & JP-A-63 288 991
- THIN SOLID FILMS, Band 80, 1981, Seiten 249-254, Lausanne, CH; M. SOKOLOWSKI et al.: "The deposition of thin films of materials with high melting points on substrates at room temperature using the pulse plasma method"
- THIN SOLID FILMS, Band 110, Nr. 1, Dezember 1983, Seiten 7-20, Lausanne, CH; J. SZMIDT et al.: "Basic properties of metal/insulator/semiconductor structures containing borazone and diamond layers produced by the reactive pulse plasma method"
- JOURNAL OF MATERIALS SCIENCE, Band 22, 1987, Seiten 1557-1562; Y. MITSUDA et al.: "The growth of diamond in microwave plasma under low pressure"

## Beschreibung

Die Erfindung betrifft ein Verfahren zur Herstellung polykristalliner Diamantschichten, bei dem Diamantkristallite bei einem Druck im Bereich von 10⁻⁵ bis 1 bar (1-10 0000 Pa) aus einer Wasserstoff und ≦ 30 % eines Kohlenstoff-haltigen Gases enthaltenden Gasphase mittels Chemical Vapour Deposition (CVD) auf einem auf eine Temperatur im Bereich von 450 bis 1200 °C aufgeheizten Substrat abgeschieden werden.

Es ist bekannt, daß die Herstellung von synthetischem Diamant nicht nur bei hohem Druck und hoher Temperatur möglich ist, sondern auch bei Atmosphärendruck oder im Unterdruckbereich auf dem Wege der chemischen Gasphasenabscheidung (CVD) erfolgen kann (hierzu wird verwiesen auf US-PS 3 030 187).

Für die Morphologie von mittels CVD aus der Gasphase abgeschiedenen Schichten wie auch für den zeitlichen Verlauf des Schichtaufbaus spielt neben den Abscheideparametern Druck, Konzentration der Reaktanden in der Gasphase und Temperatur der Gasphase auch die Beschaffenheit der Substratoberfläche eine Rolle. Vorteilhaft ist z.B. das Aufrauhen von Substratoberflächen mittels körniger Schleifmittel aus oder mit insbesondere Hartstoffen oder das Aufstreuen von Pulvern, insbesondere aus Hartstoffen, auf die Substratoberfläche.
Beiden Methoden zur Vorbereitung der Substratoberflächen haften jedoch gewisse Nachteile an: Die Substrate müssen in jedem Fall außerhalb des zum Abscheiden der Diamantschichten eingesetzten Reaktors vorbereitet werden, was immer die Gefahr einer Verunreinigung der Substratoberflächen insbesondere wegen ihrer relativ großen Oberflächenrauhigkeit mit sich bringt. Durch das Aufstreuen von Hartstoffpulvern, z.B. durch Aufbringen von durch Hochdrucksynthese hergestellten Diamantpulvern, wird ein homogenes Schichtdickenwachstum, außer durch die Gefahr des Einbringens von Verunreinigungen, auch dadurch beeinträchtigt, daß Pulverschichten schwierig homogen auf das Substrat aufbringbar sind. Das aufgebrachte Pulvermaterial kann beim Einbringen der Substrate in den Reaktor leicht verloren gehen oder in Oberflächenbereichen verschoben werden, was in beiden Fällen zu Störungen des späteren Schichtaufbaus führt. Um diese unerwünschten Effekte zu vermindern, ist versucht worden, eine Bekeimung der Substratoberflächen durch Aufbringen von Diamantpulver-haltigen Suspensionen vorzunehmen. Dadurch wird die Homogenität der Bekeimung der Substratoberflächen zwar verbessert, über die Bearbeitungsschritte Suspendieren und Entfernen überschüssiger flüssiger Phase entsteht jedoch eine zusätzliche Gefahr der Verunreinigung der Substratoberflächen. In allen Fällen ist der Rückgriff auf mittels Hochdrucksynthese hergestellte Diamantpulver zur Bekeimung von Substratoberflächen nachteilig, da diese Pulver in der Regel herstellungsbedingt mit Fremdatomen wie z.B. Eisen, Nickel, Titan verunreinigt sein können und diese Verunreinigungen mit den bekeimten Substraten in den Abscheideprozeß zur in situ-Bildung von Diamantschichten eingeschleppt werden.

Bei der in situ-Herstellung von Diamantschichten ergibt sich ein weiteres Problem daraus, daß ein mehrmaliges Bekeimen der Substratoberflächen im Verlaufe des Schichtwachstumsprozesses wünschenswert ist: hierzu muß der Schichtwachstumsprozeß jedesmal mit der Gefahr einer Verunreinigung der bereits abgeschiedenen Diamantschicht unterbrochen werden, weil das Substrat für jeden neuen Bekeimungsschritt aus dem Reaktor entfernt werden muß.

Der Erfindung liegt die Aufgabe zugrunde, ein gegenüber dem eingangs genannten Verfahren verbessertes Verfahren zur Herstellung von polykristallinen Diamantschichten auf einem Substrat zu schaffen, das die Gefahr der Verunreinigung während der Bekeimung der Substratoberfläche mit Diamantkristalliten entscheidend verringert, das die Ausbildung homogener, zusammenhängender Diamantschichten auf dem Substrat reproduzierbar sicherstellt und das auch eine mehrmalige Bekeimung der Substratoberflächen im Verlauf des Gesamtbeschichtungsprozesses unter höchstreinen Bedingungen gestattet.

Diese Aufgabe wird erfindungsgemäß dadurch gelöst, daß das Substrat mit einer Gasphase eines zeitlich variierenden Energieinhaltes in Kontakt gebracht wird, derart, daß das Substrat mindestens zu Beginn des Abscheideprozesses mit einer Gasphase eines zur Nukleation von Diamantkristalliten in der Gasphase geeigneten Energieinhaltes in Kontakt ist, wonach das Substrat mit einer Gasphase eines gegenüber dem Anfangszustand erhöhten Energieinhaltes in Kontakt gebracht wird und weitere Diamantkristallite in situ auf der mit in der Gasphase gebildeten Diamantkristalliten bekeimten Substratoberfläche gebildet werden.

Nach vorteilhaften Weiterbildungen des erfindungsgemäßen Verfahrens wird ein Plasma-induzierter CVD-Prozeß angewendet, bei dem vorzugsweise ein Mikrowellenplasma erzeugt wird.

Dadurch, daß die für den Abscheideprozeß erforderliche Energie zeitlich variiert wird, derart, daß die Energie zu Beginn des Abscheideprozesses so gedrosselt wird, daß eine Nukleation von Diamantkeimen in der Gasphase stattfindet, die sich auf dem Substrat abscheiden, wonach die Energiezufuhr so gesteigert und dann konstant gehalten wird, daß weitere Diamantkristallite in situ auf dem bekeimten Substrat gebildet werden, wobei die zeitliche Variation der Energie-zufuhr während des Prozeßablaufes auch mehrmals vorgenommen werden kann, wird ein pulsierendes Mikrowellenplasma erzeugt, mit dessen Hilfe der Bekeimungsprozeß innerhalb des Reaktors ohne Prozeßunterbrechung ausgeführt werden kann und der auch beliebig Oft im Verlauf des Abscheideprozesses wiederholt werden kann, so daß die Abscheiderate der in situ abgeschiedenen Diamantschicht gegenüber einem Abscheideprozeß ohne mehrmalige Bekeimung des Substrates erhöht wird.

Das Pulsieren kann nach einer vorteilhaften Weiterbildung des erfindungsgemäßen Verfahrens dadurch erzeugt werden, daß zu Beginn des Abscheideprozesses die in den Reaktor eingespeiste Mikrowellenenergie einer Frequenz von 2,45 GHz mit einer Frequenz von etwa 10 Hz einer Mikrowellenleistung im Bereich von 400 bis 1300 W zeitlich variiert wird und daß nach einer Dauer von etwa 30 min eine konstante Mikrowellenleistung von etwa 1000 W eingestellt wird, die über eine Dauer von etwa 900 min aufrechterhalten wird.
Dadurch wird bei Beginn des Plasmaabscheideprozesses oder bei mehrmaliger Wiederholung der puslierenden Energiezufuhr auch in seinem Verlauf die die Gasentladung unterhaltende, in die Reaktionszone eingespeiste Leistung reduziert und anschließend wieder erhöht. Die Leistungsreduktion kann sowohl zeitlich zum völligen Erlöschen des Entladungsvorganges als auch zur Variation der räumlichen Ausdehnung der Entladungszone oder der Plasmadichte führen, infolgedessen steht das Substrat zeitweilig mit einer Gasphase eines zur Nukleation von Diamantkristalliten in der Gasphase geeigneten Energieinhaltes in Kontakt und zeitweilig mit einer Gasphase eines erhöhten Energieinhaltes, wobei weitere Diamantkristallite in situ auf der mit in der Gasphase gebildeten Diamantkristalliten bekeimten Substratoberfläche gebildet werden.

Dies kann auch erreicht werden, wenn nach vorteilhaften Weiterbildungen des Verfahrens gemäß der Erfindung ein thermisch induzierter CVD-Prozeß oder ein durch UV-Strahlung, z.B. gepulste Laserstrahlung, induzierter CVD-Prozeß eingesetzt werden, oder wenn eine Relativbewegung zwischen der Reaktionszone mit maximalem Energieinhalt und Substrat vorgenommen wird, derart, daß das Substrat oder die Energiequelle bei konstanter Zufuhr einer für die in situ-Züchtung von Diamantkristalliten auf dem Substrat ausreichend hohen Energie so gegeneinander verschoben werden, daß das Substrat mindestens zu Beginn des Abscheideprozesses in eine Zone mit erniedrigtem Energieinhalt gelangt, in der eine Nukleation von Diamantkristalliten erfolgt, wonach das Substrat und/oder die Energiequelle so verschoben werden, daß das Substrat in eine Zone mit erhöhtem Energieinhalt gelangt, in der weitere Diamantkristallite in situ auf der mit in der Gasphase gebildeten Diamantkristalliten bekeimten Substratoberfläche gebildet werden.

In allen oben genannten Ausbildungen des Abscheideverfahrens ist das Substrat für eine gewisse Zeit mit einer zeitlich variierenden Gasphasenzusammensetzung in Kontakt, d.h. der Sättigungsgrad der Gasphase mit den abzuscheidenden Spezies wird durch das Pulsieren zeitlich variiert. Wird der Reaktion die notwendige Reaktionsenergie nicht kontinuierlich zugeführt, wird also z.B. bei einer Plasma-induzierten Abscheidung ein gemeinhin kontinuierlich brennendes Plasma für eine kurze Zeitdauer durch ein pulsierendes Plasma ersetzt, so wird während der Zeitdauer der Leistungsverminderung eine Gasphase mit erniedrigtem Energieinhalt erzeugt, die eine Nukleation von Diamantkristalliten bereits in der Gasphase zur Folge hat. Diese Diamantkristallite verteilen sich aus der Gasphase über die gesamte Substratoberfläche und bewirken eine Bekeimung des Substrates. Diese Bekeimung führt zu einer Verkürzung des Zeitraumes, der zum Aufbau einer zusammenhängenden Diamantschicht notwendig ist. Der Bekeimungsschritt kann zu jedem beliebigen Zeitpunkt des Abscheideprozesses wiederholt werden. Dazu werden die Prozeßparameter Energiezufuhr oder Positionierung des Substrates relativ zur Reaktionszone mit maximalem Energieinhalt während des Abscheideprozesses so modifiziert, daß die Bildung von Diamantkristalliten, wie oben beschrieben, nicht in situ auf der Substratoberfläche, sondern in der über dem Substrat befindlichen Gasphase erfolgt.

Nach einer vorteilhaften Weiterbildung des erfindungsgemäßen Verfahrens werden als Substrate einkristalline Siliciumscheiben eingesetzt. Gleichermaßen sind jedoch auch Metallsubstrate, beispielsweise aus Wolfram, Titan oder Molybdän, Substrate aus oxidischen Verbindungen wie Aluminiumoxid oder Quarz, aus Graphit oder auch Siliciumnitrid geeignet.

Anhand eines Ausführungsbeispiels wird die Erfindung beschrieben und in ihrer Wirkungsweise erläutert.

Einem Reaktor, in dem auf einer beheizten Substrathalterung aus Graphit ein gereinigtes Silicium-Einkristallsubstrat von etwa 2,5 cm Durchmesser und etwa 0,25 mm Dicke, wie es auch zur Herstellung von integrierten Halbleiterschaltungen benutzt wird, montiert ist, wird Wasserstoff geregelt zugeführt. Der Gesamtfluß beträgt 200 sccm/min, der Druck im Reaktor wird auf einen Druck von etwa 50 mbar (5000 Pa) geregelt, das Substrat wird auf eine Temperatur von 950 °C aufgeheizt.

Durch Zuführen von Mikrowellenenergie mit einer Frequenz von etwa 2,45 GHz wird im Reaktor ein Plasma unterhalten. Die zugeführte Mikrowellenleistung wird im Bereich zwischen 400 W und 1300 W mit einer Frequenz von etwa 10 Hz variiert, so daß das kugelförmig ausgebildete Plasma seine optisch wahrnehmbare Ausdehnung mit dieser Frequenz zwischen einem Durchmesser von etwa 5 cm (bei einer Leistung von 1300 W) und < 0,5 cm (bei einer Leistung von 400 W) periodisch ändert.

In diesem Betriebsmodus wird dem Wasserstoffgas ein Anteil von 0,5 Methan beigemischt. Der pulsierende Plasmazustand wird für eine Zeitdauer von etwa 30 min aufrechterhalten.
Nach dieser Zeit wird die dem Plasma zugeführte Mikrowellenleistung auf einen konstanten Wert von etwa 1000 W eingestellt und der Abscheidevorgang unter unveränderten Temperatur-, Druck- und Konzentrationsbedingungen für eine Zeitdauer von etwa 900 min fortgesetzt. Auf diese Weise werden zusammenhängende Diamantschichten einer Dicke von etwa 7 µm auf den Substraten erhalten.

Bei einem Vergleichsversuch, der unter den oben beschriebenen Versuchsbedingungen, jedoch mit einer über eine Dauer von 900 min konstant eingespeisten Mikrowellenleistung von 1000 W durchgeführt wurde, wurden auf unbekeimten Substraten Diamantschichten erhalten, die die Substratoberfläche nicht gleichmäßig bedeckten, sondern an vielen Stellen Löcher und eine Schichtdicke von nur etwa 0,5 µm aufwiesen.

## Patentansprüche

1. Verfahren zur Herstellung polykristalliner Diamantschichten, bei dem Diamantkristallite bei einem Druck im Bereich von 10⁻⁵ bis 1 bar (1-100 000 Pa) aus einer Wasserstoff und ≦ 30 % eines Kohlenstoff-haltigen Gases enthaltenden Gasphase mittels Chemical Vapour Deposition (CVD) auf einem auf eine Temperatur im Bereich von 450 bis 1200 °C aufgeheizten Substrat abgeschieden werden,
dadurch gekennzeichnet,
daß das Substrat mit einer Gasphase eines zeitlich variierenden Energieinhaltes in Kontakt gebracht wird, derart, daß das Substrat mindestens zu Beginn des Abscheideprozesses mit einer Gasphase eines zur Nukleation von Diamantkristalliten in der Gasphase geeigneten Energieinhaltes in Kontakt ist, wonach das Substrat mit einer Gasphase eines gegenüber dem Anfangszustand erhöhten Energieinhaltes in Kontakt gebracht wird, und weitere Diamantkristallite in situ auf der mit in der Gasphase gebildeten Diamantkristalliten bekeimten Substratoberfläche gebildet werden.

2. Verfahren nach Anspruch 1,
dadurch gekennzeichnet,
daß als Reaktionsgas Wasserstoff mit einem Zusatz von 0,5 % eines Kohlenwasserstoffgases eingesetzt wird.

3. Verfahren nach den Ansprüchen 1 und 2,
dadurch gekennzeichnet,
daß als Substrate einkristalline Siliciumscheiben eingesetzt werden.

4. Verfahren nach den Ansprüchen 1 bis 3,
dadurch gekennzeichnet,
daß ein Plasma-induzierter CVD-Prozeß angewendet wird.

5. Verfahren nach Anspruch 4,
dadurch gekennzeichnet,
daß die für den Abscheideprozeß erforderliche Energie als Mikrowellenenergie in den Reaktor eingekoppelt wird.

6. Verfahren nach Anspruch 4,
dadurch gekennzeichnet,
daß die für den Abscheideprozeß erforderliche Energie als Hochfrequenzenergie in den Reaktor eingekoppelt wird.

7. Verfahren nach den Ansprüchen 1 bis 3,
dadurch gekennzeichnet,
daß ein thermisch induzierter CVD-Prozeß angewendet wird.

8. Verfahren nach den Ansprüchen 1 bis 3,
dadurch gekennzeichnet,
daß ein über UV-Strahlung induzierter CVD-Prozeß angewendet wird.

9. Verfahren nach mindestens einem der Ansprüche 1 bis 8,
dadurch gekennzeichnet,
daß die für den Abscheideprozeß erforderliche Energie zeitlich variiert wird, derart, daß die Energie zu Beginn des Abscheideprozesses so gedrosselt wird, daß eine Nukleation von Diamantkeimen in der Gasphase stattfindet, die sich auf dem Substrat abscheiden, wonach die Energiezufuhr so gesteigert und dann konstant gehalten wird, daß weitere Diamantkristallite in situ auf dem Substrat gebildet werden.

10. Verfahren nach Anspruch 9,
dadurch gekennzeichnet,
daß die zeitliche Variation der Energiezufuhr während des Prozeßablaufes mehrmals vorgenommen wird.

11. Verfahren nach den Ansprüchen 5, 9 und 10,
dadurch gekennzeichnet,
daß zu Beginn des Abscheideprozesses die in den Reaktor eingespeiste Mikrowellenenergie einer Frequenz von 2,45 GHz mit einer Frequenz von etwa 10 Hz einer Mikrowellenleistung im Bereich von 400 bis 1300 W zeitlich variiert wird und daß nach einer Dauer von etwa 30 min eine konstante Mikrowellenleistung von etwa 1000 W eingestellt wird, die über eine Dauer von etwa 900 min aufrechterhalten wird.

12. Verfahren nach mindestens einem der Ansprüche 1 bis 8,
dadurch gekennzeichnet,
daß eine Relativbewegung zwischen der Reaktionszone mit maximalem Energieinhalt und Substrat vorgenommen wird, derart, daß das Substrat oder die Energiequelle bei konstanter Zufuhr einer für die in situ-Züchtung von Diamantkristalliten auf dem Substrat ausreichend hohen Energie so gegeneinander verschoben werden, daß das Substrat mindestens zu Beginn des Abscheideprozesses in eine Zone mit erniedrigtem Energieinhalt gelangt, in der eine Nukleation von Diamantkristalliten erfolgt, wonach das Substrat und/oder die Energiequelle so verschoben werden, daß das Substrat in eine Zone mit erhöhtem Energieinhalt gelangt, in der weitere Diamantkristallite in situ auf der mit in der Gasphase gebildeten Diamantkristalliten bekeimten Substratoberfläche gebildet werden.

13. Verfahren nach Anspruch 12,
dadurch gekennzeichnet,
daß die Relativbewegung zwischen der Reaktionszone und dem Substrat im Verlauf des Abscheideprozesses wiederholt wird.

14. Verfahren nach mindestens einem der Ansprüche 1 bis 13,
dadurch gekennzeichnet,
daß der Druck im Reaktor auf einen Wert von etwa 50 mbar (5000 Pa) eingestellt wird.

15. Verfahren nach mindestens einem der Ansprüche 1 bis 14,
dadurch gekennzeichnet,
daß das Substrat auf eine Temperatur von 950 °C aufgeheizt wird.

16. Verfahren nach mindestens einem der Ansprüche 1 bis 15,
dadurch gekennzeichnet,
daß als Kohlenwasserstoffgas Methylgruppen enthaltende Kohlenwasserstoffgase eingesetzt werden.

17. Verfahren nach Anspruch 16,
dadurch gekennzeichnet,
daß als Kohlenwasserstoffgas Methan eingesetzt wird.

## Claims

1. A method of manufacturing polycrystalline diamond layers, in which diamond crystallites are deposited by means of Chemical Vapour Deposition (CVD) on a substrate heated to a temperature in the range from 450 to 1200°C from a gas phase comprising hydrogen and ≦ 30 % of a carbon-containing gas at a pressure in the range from 10⁻⁵ to 1 bar (1-100,000 Pa) characterized in that the substrate is contacted with a gas phase having an energy content which varies in time, such that at least at the start of the deposition process the substrate is in contact with a gas phase having an energy content which is suitable for nucleating diamond crystallites in the gas phase, after which the substrate is contacted with a gas phase having an energy content which is increased with respect to the content at the start of the process and further diamond crystallites are formed in situ on the substrate surface nucleated with diamond crystallites formed in the gas phase.

2. A method as claimed in Claim 1, characterized in that hydrogen to which 0.5 % of a hydrocarbon gas is added is used as a reaction gas.

3. A method as claimed in Claims 1 and 2, characterized in that monocrystalline silicon discs are used as substrates.

4. A method as claimed in Claims 1 to 3, characterized in that a plasma-induced CVD process is used.

5. A method as claimed in Claim 4, characterized in that the energy required for the deposition process is coupled into the reactor as microwave energy.

6. A method as claimed in Claim 4, characterized in that the energy required for the deposition process is coupled into the reactor as high-frequency energy.

7. A method as claimed in Claims 1 to 3, characterized in that a thermally induced CVD process is used.

8. A method as claimed in Claims 1 to 3, characterized in that a CVD process induced by UV radiation is used.

9. A method as claimed in any one of Claims 1 to 8, characterized in that the energy required for the deposition process is varied in time so that the energy is reduced at the start of the deposition process in such a way that diamond nuclei are nucleated in the gas phase, which nuclei are deposited on the substrate, after which the energy supply is increased and then kept constant in such a way that further diamond crystallites are formed in situ on the substrate.

10. A method as claimed in Claim 9, characterized in that the energy supply is repeatedly varied in time during the process.

11. A method as claimed in Claims 5, 9 and 10, characterized in that at the start of the deposition process the microwave energy fed into the reactor at a frequency of 2.45 GHz is varied in time by a frequency of approximately 10 Hz originally from a microwave power source whose power ranges from 400 to 1300 W and in that after a period of approximately 30 min the microwave power is adjusted at a constant value of approximately 1000 W which is maintained for a period of approximately 900 min.

12. A method as claimed in any one of Claims 1 to 8 characterized in that the reaction zone with the maximum energy content and the substrate are moved relative to each other so that with a constant supply of energy which is sufficiently high for the in situ growth of diamond crystallites on the substrate, this substrate or the energy source are moved relative to each other in such a way that at least at the start of the deposition process the substrate is in a zone having a reduced energy content, in which zone diamond crystallites are nucleated, after which the substrate and/or the energy source are moved in such a way that the substrate is in a zone having an increased energy content, in which zone further diamond crystallites are formed in situ on the substrate surface nucleated with diamond crystallites formed in the gas phase.

13. A method as claimed in Claim 12, characterized in that the relative movement between the reaction zone and the substrate is repeated in the course of the deposition process.

14. A method as claimed in any one of Claims 1 to 13, characterized in that the pressure in the reactor is adjusted to a value of approximately 50 mbar (5000 Pa).

15. A method as claimed in any one of Claims 1 to 14, characterized in that the substrate is heated to a temperature of 950°C.

16. A method as claimed in any one of Claims 1 to 15, characterized in that hydrocarbon gases containing methyl groups are used.

17. A method as claimed in Claim 16, characterized in that methane is used as a hydrocarbon gas.

## Revendications

1. Procédé de fabrication de couches en diamant polycristallin, dans lequel à une pression comprise entre 10⁻⁵ et 1 bar (1 - 100.000 Pa), à partir d'une phase gazeuse comportant de l'hydrogène et ≦ 30% d'un gaz à teneur de carbone, des cristallites de diamant sont déposées au moyen d'un procédé de dépôt en phase vapeur (CVD) sur un substrat chauffé à une température comprise entre 450 et 1200°C, caractérisé en ce que le substrat est mis en contact avec une phase gazeuse présentant une capacité énergétique qui varie dans le temps, de manière qu'au moins jusqu'au commencement du procédé de dépôt le substrat est en contact avec une phase gazeuse présentant une capacité énergétique susceptible de nucléer des cristallites de diamant dans la phase gazeuse, après quoi le substrat est mis en contact avec une phase gazeuse présentant une capacité énergétique accrue par rapport à celle disponible au commencement du procédé et que d'autres cristallites de diamant sont formées in situ sur la surface de substrat nucléée comportant des cristallites de diamant formées dans la phase gazeuse.

2. Procédé selon la revendication 1, caractérisé en ce qu'on utilise comme gaz de réaction de l'hydrogène auquel on a ajouté 0,5% de gaz d'hydrocarbure.

3. Procédé selon les revendications 1 et 2, caractérisé en ce qu'on utilise comme substrats des disques de silicium monocristallins.

4. Procédé selon les revendications 1 à 3, caractérisé en ce qu'on utilise un procédé de dépôt en phase vapeur activé par plasma.

5. Procédé selon la revendication 4, caractérisé en ce que l'énergie indispensable pour le procédé de dépôt est introduite dans le réacteur comme énergie à micro-ondes.

6. Procédé selon la revendication 4, caractérisé en ce que l'énergie indispensable pour le procédé de dépôt est introduite dans le réacteur comme énergie à haute fréquence.

7. Procédé selon les revendications 1 à 3, caractérisé en ce qu'on utilise un procédé de dépôt en phase vapeur activé thermiquement.

8. Procédé selon les revendications 1 à 3, caractérisé en ce qu'on utilise un procédé de dépôt en phase vapeur activé par rayonnement ultraviolet.

9. Procédé selon au moins l'une des revendications 1 à 8, caractérisé en ce que l'énergie indispensable pour le procédé de dépôt est variée tellement que l'énergie au commencement du procédé de dépôt est réduite de manière qu'il se produit une nucléation de germes de diamant dans la phase gazeuse pour être déposés sur le substrat, après quoi l'alimentation en énergie est tellement augmentée pour être maintenue à un niveau constant que d'autres cristallites de diamant sont formées in situ sur le substrat.

10. Procédé selon la revendication 9, caractérisé en ce que lors du procédé la variation dans le temps de l'alimentation en énergie peut être effectuée plusieurs fois.

11. Procédé selon les revendications 5, 9 et 10, caractérisé en ce qu'au commencement du procédé de dépôt l'énergie à micro-ondes introduite dans le réacteur et présentant une fréquence de 2,45 GHz est variée dans le temps avec une fréquence de l'ordre de 10 Hz dans la gamme de puissances de micro-ondes comprise entre 400 et 1300 W et que, après une période de quelque 30 minutes, une puissance à micro-ondes constante de l'ordre de 1000 W est ajustée qui est maintenue pendant une période d'approximativement 900 minutes.

12. Procédé selon au moins l'une des revendications 1 à 8, caractérisé en ce que la zone de réaction présentant la capacité énergétique maximale et le substrat sont déplacés l'un par rapport à l'autre de manière que le substrat ou la source d'énergie sont tellement déplacés dans le cas d'une alimentation constante en énergie suffisamment élevée pour la formation in situ de cristallites de diamant sur le substrat, que le substrat au moins jusqu'au commencement du procédé de dépôt arrive dans une zone présentant une capacité énergétique réduite dans laquelle se déroule une nucléation de cristallites de diamant, après quoi le substrat et/ou la source d'énergie sont déplacés de manière telle que le substrat arrive dans une zone présentant une capacité énergétique accrue dans laquelle des cristallites de diamant ultérieures sont formées in situ sur la surface de substrat nucléée avec des cristallites de diamant formées dans la phase gazeuse.

13. Procédé selon la revendication 12, caractérisé en ce que lors du procédé de dépôt la zone de réaction et le substrat peuvent être déplacés plusieurs fois l'un par rapport à l'autre.

14. Procédé selon au moins l'une des revendications 1 à 13, caractérisé en ce que la pression dans le réacteur est ajustée sur une pression de l'ordre de 50 mbar (5000 Pa).

15. Procédé selon au moins l'une des revendications 1 à 14, caractérisé en ce que le substrat est chauffé jusqu'à une température de 950 °C.

16. Procédé selon au moins l'une des revendications 1 à 15, caractérisé en ce qu'on utilise comme gaz d'hydrocarbure des groupes de méthyle à teneur de gaz d'hydrocarbure.

17. Procédé selon la revendication 16, caractérisé en ce qu'on utilise du méthane comme gaz d'hydrocarbure.
